Europäisches Patentamt

European Patent Office

Office européen des brevets

(19)

(11) Numéro de publication: **0 139 063**
**A1**

# (12) DEMANDE DE BREVET EUROPEEN

(21) Numéro de dépôt: **83402064.6**

(22) Date de dépôt: **24.10.83**

(51) Int. Cl.⁴: **H 01 L 21/60**

(43) Date de publication de la demande:
**02.05.85 Bulletin 85/18**

(84) Etats contractants désignés:
**CH DE GB IT LI NL SE**

(71) Demandeur: **SINTRA-ALCATEL Société Anonyme dite:**
**26, rue Malakoff B.P. 245**
**F-92600 Asnieres Cedex(FR)**

(72) Inventeur: **Droguet, Jean-Paul**
**120, avenue Marceau**
**F-92400 Courbevoie(FR)**

(72) Inventeur: **Vernay, Michel**
**16, Rue du Pont aux Choux**
**F-75003 Paris(FR)**

(72) Inventeur: **Teissier, Gérard**
**11, Avenue de la Redoute**
**F-92600 Asnieres(FR)**

(74) Mandataire: **Boireau, Jacques et al,**
**Thomson-CSF SCPI 173, boulevard Haussmann**
**F-75379 Paris Cedex 08(FR)**

(54) **Procédé de substitution d'un composant électronique connecté aux pistes conductrices d'un substrat porteur.**

(57) L'invention a pour objet un procédé de substitution d'un composant électronique (1A) à un composant (1) analogue connecté aux pistes conductrices (3) d'un substrat porteur (2) par l'intermédiaire de fils de liaison (4). On coupe les pistes conductrices en aval par rapport au composant (1) à mettre hors service, des zones où les fils de liaison (4) sont connectés aux pistes, puis on positionne le composant (1A) de remplacement sur la face supérieure encollée du composant (1), et on le relie aux pistes par l'intermédiaire de fils de liaison (4A) indépendants des précédents.

L'invention s'applique notamment aux circuits intégrés et aux circuits résistifs à couches minces déposées sous vide.

FIG. 2

EP 0 139 063 A1

<u>Procédé de substitution d'un composant électronique connecté aux</u>
<u>pistes conductrices d'un substrat porteur</u>

La présente invention a pour objet un procédé de substitution
d'un composant électronique connecté aux pistes conductrices d'un
substrat porteur, elle s'applique notamment aux composants du
type "puce" montés sur des circuits réalisés en technologie hybride.

Dans cette technologie, les composants électroniques sont
reportés sur un substrat porteur recouvert de pistes conductrices et
des liaisons entre les points de connexion des composants et les pistes
conductrices sont réalisées à l'aide de fils, par exemple en or ou en
aluminium, qui sont soudés par thermocompression ou à l'aide d'ultrasons.

La substitution d'un composant à un autre sur un substrat est une
opération qui peut être nécessaire pour différentes raisons dont la
plus classique est la remise en état de marche d'un circuit défaillant
par suite du mauvais fonctionnement d'un composant.

En raison des faibles dimensions des composants et des pistes
qui les desservent, la substitution d'un composant à un autre est une
opération délicate à réaliser, notamment parce qu'elle implique classiquement une déconnexion du composant fautif et son enlèvement.

En effet, il faut enlever les fils de connexion du composant
défectueux au ras de la piste du substrat sans blesser celle-ci et sans
rompre le fil en plusieurs morceaux or celui-ci fait en général moins
de cent microns et typiquement vingt cinq microns de diamètre et des
copeaux ou tronçons microscopiques risquent d'aller créer des courts
circuits en d'autres points du circuit. Il ne faut pas non plus blesser
la piste conductrice ce qui risquerait d'interrompre la continuité
électrique ou empêcherait l'adhérence de la connexion de réparation.

Enlever le composant défectueux est également difficile. La
colle polymérisée généralement utilisée cède difficilement. A essayer
il peut se produire des ruptures du substrat qui rendent toute réparation impossible, ou des ruptures du composant dont les éclats encore
adhérents, doivent alors être éliminés un par un ; de toute façon si la
colle cède, l'état de surface de la plage de collage obtenue est de
faible qualité. Quant à essayer de chauffer le composant défectueux, si cela est efficace cela entraîne des contraintes thermiques et des risques de décollement des composants voisins fragilisant ainsi le circuit de façon inacceptable.

Une pratique, parfois utilisée, consiste à laisser en place le composant défectueux et à reporter sur celui-ci un nouveau composant, après avoir enlevé les connexions initiales une à une.

Jusqu'ici ceci n'était praticable que si le composant possèdait un faible nombre de fils d'interconnexion (une dizaine par exemple) car en cas contraire les risques étaient trop grands et le temps opératoire trop important pour que la méthode en vaille la peine. Cette méthode était par ailleurs impraticable quand le corps du composant, comme c'est souvent le cas, devait être relié à un potentiel par l'intermédiaire de la plage de soudage car il n'y avait plus contact de la face postérieure avec la plage de soudage.

La présente invention propose donc un procédé de substitution d'un composant électronique électriquement relié aux pistes conductrices d'un substrat porteur par l'intermédiaire de fils de liaison qui remédie aux inconvénients évoqués ci-dessus.

Selon une caractéristique de l'invention, le procédé de substitution de composant comporte les phases suivantes :
- coupure au laser des pistes conductrices en aval, par rapport au composant à mettre hors service, des zones où les fils de liaison sont connectés aux pistes,
- encollage de la face supérieure du composant à mettre hors service,
- positionnement d'un composant de remplacement sur le composant à mettre hors service,
- durcissement de la colle par cuisson,
- interconnexion du composant de remplacement avec les pistes conductrices en deça des coupures.

Les caractéristiques et avantages de l'invention sont précisés au cours de la description suivante et en relation avec les figures ci-dessous référencées.

La figure 1 présente un exemple de montage classique d'un composant électronique sur un substrat.

La figure 2 présente un exemple de montage obtenu après application du procédé selon l'invention.

La figure 3 présente un substrat dont les pistes ont été modifiées pour permettre la mise en oeuvre du procédé selon l'invention.

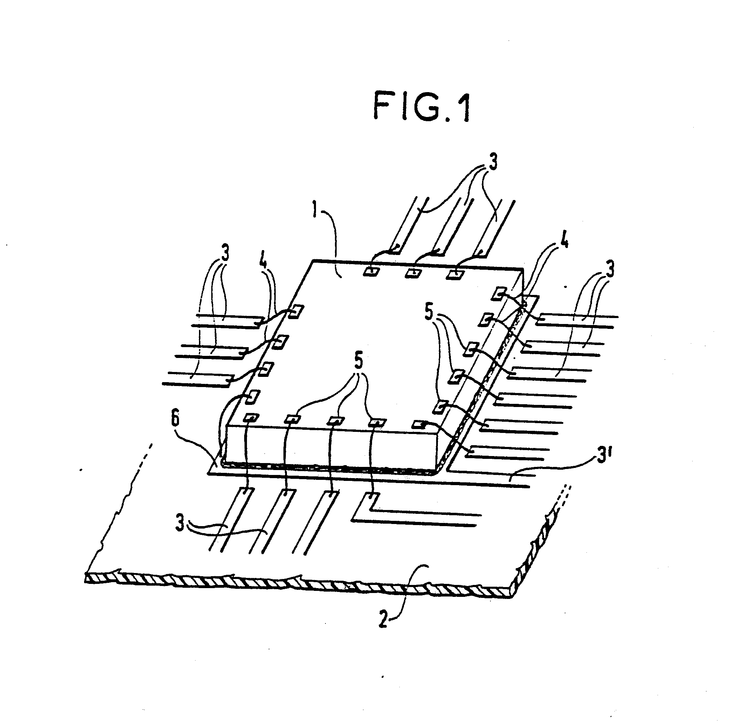

De manière classique telle que présentée figure 1, un composant électronique 1, de type puce est monté sur un substrat porteur, isolant 2 recouvert d'une pluralité de pistes conductrices 3, qui alimentent le composant 1 par l'intermédiaire de fils de liaison 4 qui sont soudés à leurs extrémités d'une part sur des zones de connexion 5 du composant d'autre part sur les pistes.

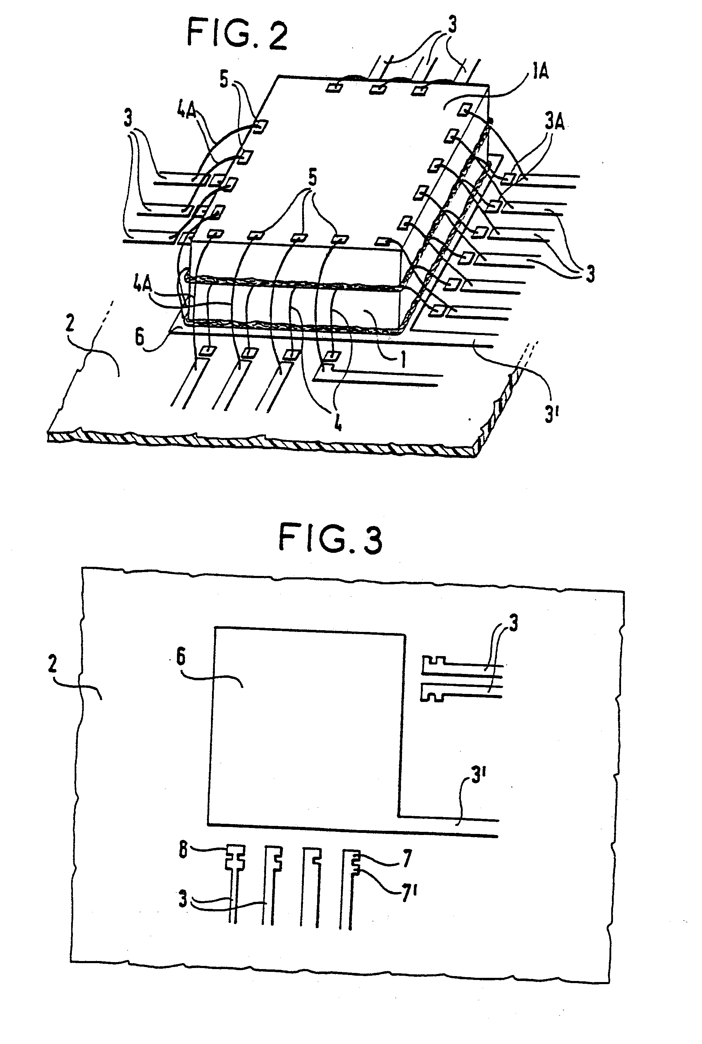

Si l'on désire remplacer ce composant 1 par un autre et que l'on veut éviter les inconvénients dus à son retrait qui ont été évoqués plus haut, on laisse ce composant 1 en place et en premier lieu on coupe les pistes conductrices 3 auxquelles il est connecté de manière à le mettre hors circuit, ainsi que le montre la figure 2.

Ainsi les fils 4 reliant les zones de connexion 5 du composant 1 restent reliées à des portions 3a de pistes 3 qui sont électriquement isolées de ces pistes par la coupure effectuée.

Cette coupure de piste peut facilement être obtenue par utilisation d'un laser dont le spot sublime le métal de la couche sur laquelle il est projeté, notamment dans le cas d'un module hybride à couches minces.

En second lieu on encolle le composant 1 sur sa face supérieure qui est accessible de manière à pouvoir venir y positionner un composant 1A destiné à le remplacer fonctionnellement. Cet encollage s'effectue classiquement par exemple à l'aide d'une résine époxy qui est déposée par exemple avec un tampon dans la partie centrale de la face supérieure qui est comprise entre les zones de connexion 5 des fils.

L'épaisseur déposée est d'environ quarante à deux cents microns, ce qui élimine les problèmes de positionnement en saillie ou de guingois du composant de remplacement 1A, étant entendu que ce composant de remplacement est orienté de manière identique au composant 1, que l'on met hors service.

Le positionnement du composant de remplacement s'effectue de manière classique, identique à celle employée pour un premier composant.

Après positionnement la colle est durcie, dans l'exemple présenté, elle est portée à température de polymérisation.

Ensuite on interconnecte par thermocompression où à l'aide d'ultrasons, des fils d'interconnexion 4A d'une part sur les zones de connexion 5A disposées sur la face supérieure qui est accessible sur le composant de remplacement 1A et d'autre part sur les pistes 5.

Ainsi on évite les problèmes qu'auraient occasionné la coupe des fils de connexion 4 qui restent en place, mais qui ne sont plus utilisés.

Au cas où l'on désire maintenir le corps du composant 1A à un potentiel donné, ce qui était réalisé par la plage de collage métallisée 6 sous le composant 1, il suffit de ne pas couper la piste d'amenée 3' du potentiel à cette plage. Si comme cela est toujours le cas pour les composants complexes, ce même potentiel se trouve reporté sur la face supérieure du composant par un fil d'interconnexion et celui-ci reste alimenté, on retrouve bien le potentiel désiré en face supérieure. Le collage du composant de remplacement 1A se fait alors avec une résine conductrice assurant ainsi la continuité électrique désirée.

Lors de la conception des pistes conductrices il est éventuellement possible de prévoir une double plage d'interconnexion 7, 7' sur chaque piste ou une zone rétrécie 8 pour la future coupure (Fig.3).

Ce procédé s'applique avantageusement aux circuits intégrés et aux circuits résistifs à couches minces déposées sous vide, il présente l'avantage d'être aisément automatisable.

La protection finale du circuit réparé est faite selon la technologie du circuit et peut être soit sans protection notamment dans le cas des hybrides en boîtier hermétique, soit avec une protection par dépôt par exemple de vernis de type parylène, soit encore par enrobage.

Cette méthode est également applicable à l'industrie des circuits intégrés quand le circuit en question est monté dans un boîtier possédant des liaisons susceptibles d'être coupées par un procédé quelconque et que le coût de ce boîtier justifie sa récupération.

Bien entendu il est éventuellement possible si le composant de remplacement 1A s'avère défectueux, de monter selon le même principe de l'invention un autre composant superposé aux deux premiers.

REVENDICATIONS

1/ Procédé de substitution d'un composant électronique électriquement relié aux pistes conductrices (3) d'un substrat porteur par l'intermédiaire de fils de connexion (4), caractérisé en ce qu'il comporte les phases successives suivantes :

- coupure des pistes conductrices (3) en aval, par rapport au composant (1) à mettre hors service, des zones où les fils de liaison (4) sont connectés aux pistes,

- encollage du composant 1 sur sa face supérieure accessible

- positionnement d'un composant de remplacement (1A) sur le composant à mettre hors service,

- durcissement de la colle par cuisson,

- interconnexion du composant de remplacement (1A) avec les pistes conductrices (3).

2/ Procédé de substitution d'un composant électronique selon la revendication 1, pour composant ayant sa face support inférieure et sa face supérieure portées à un potentiel donné, caractérisé en ce que l'on conserve intacte la piste (3') d'amenée du potentiel donné et que l'on réalise la connexion du composant de remplacement (1A) avec cette piste par l'intermédiaire du composant (1) au moyen d'une colle conductrice.

# FIG.1

FIG.2

FIG.3

Office européen
des brevets

**RAPPORT DE RECHERCHE EUROPEENNE**

Numéro de la demande

EP 83 40 2064

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X | PATENTS ABSTRACTS OF JAPAN, vol. 5, no. 167, 24 octobre 1981, page 43E79; & JP - A - 56 94753 (SUWA SEIKOSHA K.K.) 31-07-1981 * Résumé * | 1,2 | H 01 L 21/60 |
| A | IBM TECHNICAL DISCLOSURE BULLETIN, vol. 24, no. 12, mai 1982, page 6371, New York, USA; M.L. BULLER et al.: "Back-to-back chip pack" | | |

DOMAINES TECHNIQUES
RECHERCHES (Int. Cl. ³)

H 01 L
H 05 K

Le présent rapport de recherche a été établi pour toutes les revendications

| Lieu de la recherche | Date d'achèvement de la recherche | Examinateur |
|---|---|---|
| LA HAYE | 25-06-1984 | PEETERS S. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82